# EUROPEAN PATENT SPECIFICATION

(11) **EP 3 440 716 B1**
(45) Date of publication and mention of the grant of the patent: **11.03.2020**
(21) Application number: 17718456.1
(22) Date of filing: 06.04.2017
(51) Int. Cl.: H01L 35/32

(54) **FLEXIBLE THERMOELECTRIC ENGINE**
FLEXIBLER THERMOELEKTRISCHER MOTOR
MOTEUR THERMOÉLECTRIQUE FLEXIBLE

(30) Priority: 06.04.2016 US 201662318797 P
(43) Date of publication of application: 13.02.2019
(73) Proprietor: Magna Seating Inc., Aurora, Ontario L4G 7K1 (CA)
(72) Inventor: KOZLOWSKI, Eric, Oakland Township, MI 48363 (US); DAVIS, Jason, Commerce Township, MI 48390 (US); STEPANOV, Artur, Troy, MI 48083 (US)
(74) Representative: Glawe, Delfs, Moll
(86) International application number: PCT/US2017/026311
(87) International publication number: WO 2017/176972

(56) References cited:
- US-A- 3 240 628
- US-A1- 2009 014 046
- US-A1- 2009 025 770
- US-A1- 2015 311 420

## Description

### CROSS-REFERENCE TO RELATED APPLICATIONS

This application claims priority to United States Provisional Application No. 62/318,797, filed on April 6, 2016.

### BACKGROUND OF THE INVENTION

### 1. Field of the Invention

The present invention relates to a thermoelectric engine, and more particularly, to a flexible thermoelectric engine for heating and cooling a surface.

### 2. Description of Related Art

Thermoelectric devices which operate according to the Peltier effect are commonly known in the art. The Peltier effect creates a temperature difference between two electrical junctions. A thermoelectric device typically includes an array of alternating N- and P- type semiconductors soldered between two substrates. The semiconductors are electrically connected series and create a hot side and a cool side when voltage is applied to the series of semiconductors.

Automotive vehicles include one or more seat assemblies having a seat cushion and a seat back for supporting a passenger or occupant above a vehicle floor. Each of the seat cushion and seat back typically include a resilient foam pad encased in a flexible trim cover of cloth or leather. It is commonly known to provide seat assemblies with heating and cooling mechanisms for selectively heating and cooling the surface of the seat for seat occupant comfort. These known heating and cooling mechanisms are typically independent mechanisms. For example, it is common to provide an electric wire heating pad between the foam pad and trim cover of the seat cushion or seat back which is electrically actuated by the power from the vehicle battery to electrically charge the heating pad and provide heat to the surface of the seat cushion or seat back. It is also known to provide fans and air ducts to force cool air through the foam pad and trim cover and provide cool air to the surface of the seat cushion or seat back. It is also known to provide fans and ducts to draw warm, moist air away from the seating surface to provide a gradual cooling effect.

However, current heating and cooling mechanisms require a fair amount of time and power to generate sufficient heat or cool air to affect the temperature of the seat assembly and the desired comfort for the seat occupant.

It is desirable, therefore, to provide a thermoelectric engine for rapidly heating or cooling a surface, such as the seating surface of a seat assembly. More particularly, it is desirable to provide a flexible thermoelectric engine for heating and cooling the surface such that the thermoelectric engine may flex to conform to the desired shape of the surface and/or flex during use of the surface.

US 3,240,628 discloses a thermoelectric panel having thermoelectric elements joined by bridges, wherein suitable insulation, such as mica sheets electrically insulate the bridges from adjacent plates. The thermoelectric elements are arranged between the insulation sheets corresponding to insulating layers of the top and bottom circuits.

US 2015/0311420 A1 discloses a thermoelectric module including a pair of support substrates, a wiring conductor disposed on each of one main faces opposing each other of the pair of support substrates, and thermoelectric elements electrically connected to the wiring conductor. A sealing member is disposed on a periphery of the region between the one main faces opposing each other of the pair of support substrates. Thermoelectric elements are arranged between a pair of support substrates which are obtained by laminating a copper plate on an insulating support substrate.

US 2009/0014046 A1 discloses a flexible thermoelectric device with a plurality of thermoelectric pairs being arranged between a first substrate and a second substrate, the substrates being made of polymer material.

### SUMMARY OF THE INVENTION

A thermoelectric engine for heating and cooling a surface with the features of claim 1 is provided.

### BRIEF DESCRIPTION OF THE DRAWINGS

Advantages of the present invention will be readily appreciated as the same becomes better understood by reference to the following detailed description when considered in connection with the accompanying drawings wherein:
Figure 1 is a perspective view of a flexible thermoelectric engine according to a preferred embodiment of the invention;
Figure 2 is an exploded perspective view of the flexible thermoelectric engine of Figure 1;
Figure 3 is cross-sectional view of the flexible thermoelectric engine;
Figure 4 is cross-sectional view of a flexible circuit of the thermoelectric engine of Figure 1;
Figure 5 is a perspective view of a pair of interconnected flexible circuits of the thermoelectric engine; and
Figure 6 is a perspective view of the flexible circuits of Figure 5 forming the top and bottom circuits of the thermoelectric engine.

### DETAILED DESCRIPTION OF THE EMBODIMENTS

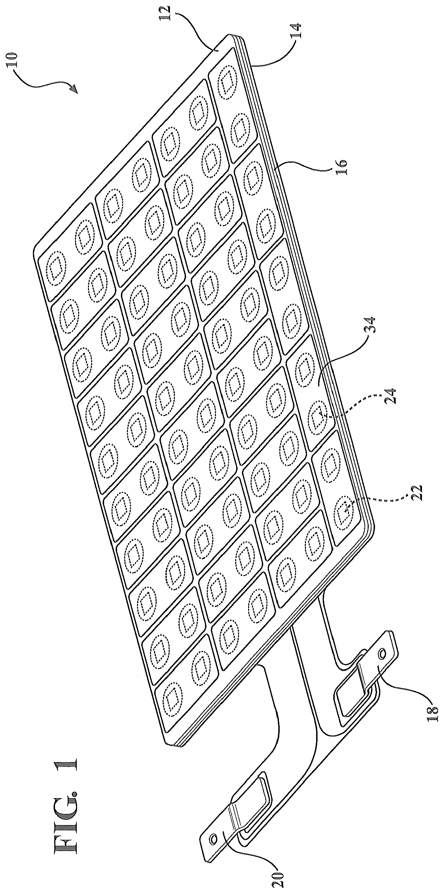

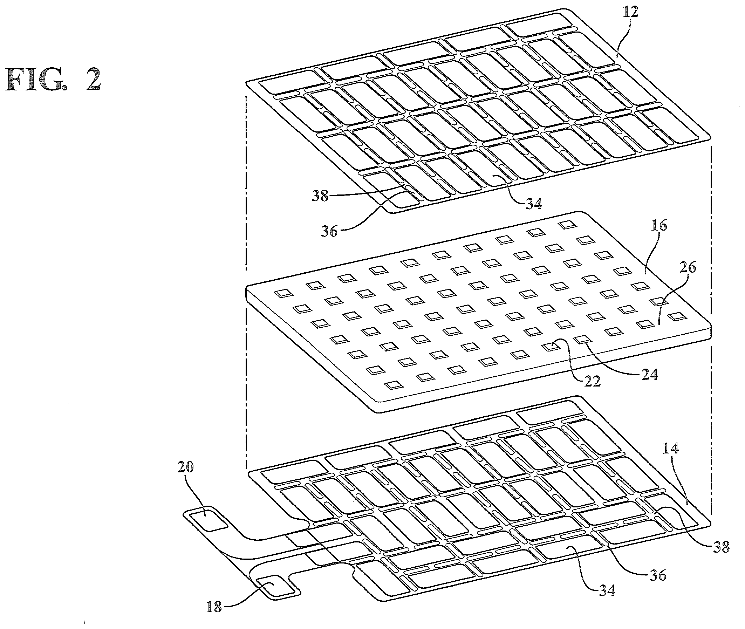

Referring to the Figures, wherein like numerals indicate like or corresponding parts throughout the several views, a flexible thermoelectric engine for heating and cooling a surface, such as a seating surface of a vehicle seat, is shown at 10. Referring to Figures 1 and 2, the flexible thermoelectric engine 10 includes a flexible top circuit 12, a flexible bottom circuit 14, and a thermoelectric or Peltier device 16 positioned or sandwiched between the top and bottom circuits 12, 14. The engine 10 further includes a pair of positive and negative electrical terminals or connectors 18, 20 electrically connected and extending from one of the top or bottom circuits 12, 14 for connecting the engine to a power source. A thermistor (not shown) may be embedded into either the top or bottom circuit 12, 14 for monitoring the surface temperature of the engine 10 as desired.

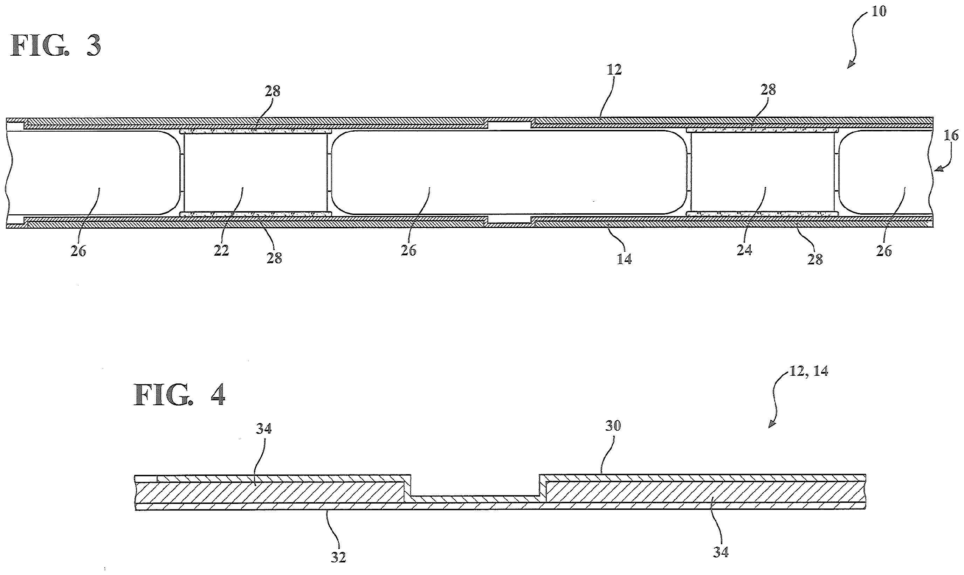

Referring to Figure 3, a cross-sectional view of the flexible thermoelectric engine 10 is shown. More specifically, and as shown in Figure 3, the engine 10 includes the generally planar top electrical circuit 12, the generally planar bottom electrical circuit 14, and the thermoelectric device 16 sandwiched between the top and bottom circuits 12, 14 to form a generally thin, flat and planar thermoelectric engine 10. It should be appreciated that the size, shape and dimensions of the engine 10 may vary as desired without varying from the scope of the invention. The thermoelectric, or Peltier, device 16 is comprised of alternating N-elements 22 and P-elements 24 spaced apart by an insulator or electrical isolator 26 and electrically connected in series. The preferred materials for the insulators 26 for managing heat and having lower thermal conductivity and high flexibility include polyurethane foam, wool, cotton, polyolefin, polypropylene, and the like. A layer of solder paste 28 electrically interconnects the top and bottom circuits 12, 14 to each of the N-elements 22 and P-elements 24 of the device 16 and mechanically bonds or secures the device 16 between the top and bottom circuits 12, 14. The device 16 is soldered between the top and bottom circuits 12, 14 by reflow soldering, which can include convection reflow, hot bar reflow, in-line conduction reflow or infrared reflow. Alternatively, induction reflow soldering may be implemented to focus heating locally only on the solder joints.

Referring to Figure 4, a cross-sectional view of one of the top or bottom circuits 12, 14 is shown in more detail. The circuit 12, 14 includes a cover layer 30 and a base layer 32 each formed of polyimide. A plurality of spaced apart copper conductors 34 are adhered to each of the cover layer 30 and base layer 32 to form the planar top and bottom circuits 12, 14. It should be appreciated, however, that each or either circuit 12, 14 could be made without the cover layer 30 wherein the copper conductors 34 are adhered to only a base layer 32. Further, the copper conductors 34 may be surface plated to improve solderability of the conductors 34 to N-elements 22 and P-elements 24. Further, referring again to Figure 2, the polyimide cover layer 30 and/or base layer 32 includes elongated slots 36 formed therein which are spaced apart and interconnected by bridge portions 38 of the polyimide adjacent each of the copper conductors 34 to improve the flexibility of the circuits 12, 14. As shown in Figure 2, the slots 36 may be arranged in both the longitudinal and lateral, or X and Y, directions of the circuits 12, 14 to provide multi-directional flexibility while maintaining electrical connectivity between the copper conductors 34.

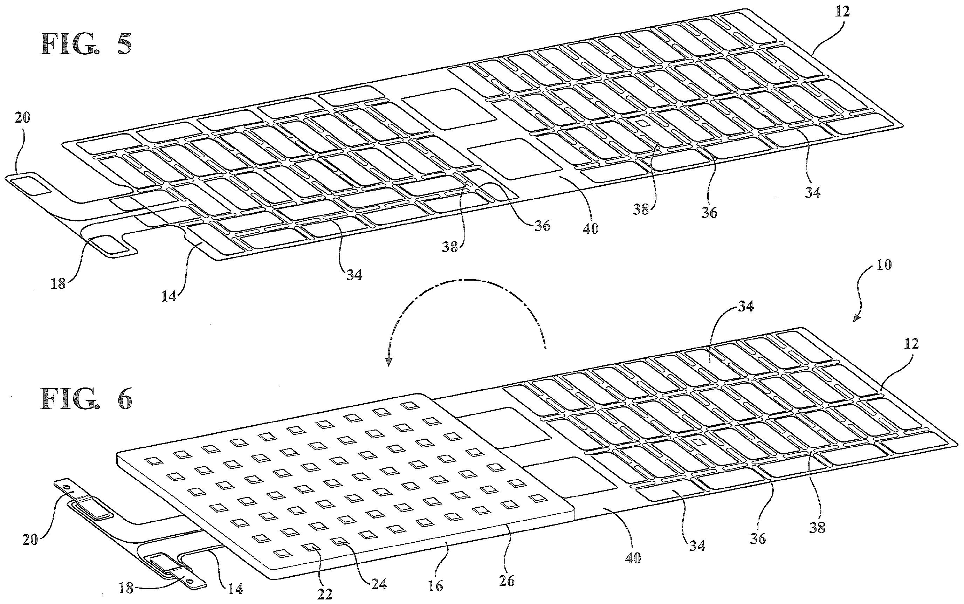

Finally, referring to Figures 5 and 6, the top and bottom circuits 12, 14 may also be interconnected by a flexible hinge of polyimide material shown at 40 creating a single flexible circuit which may be folded around the thermoelectric device 16 to form the top and bottom circuits 12, 14.

In conclusion, the assembled flexible thermoelectric engine 10 forms a multi-directional flexible engine 10 for heating and cooling a surface. That is, the flexible insulators 26 spaced between the elements 22, 24 allow the thermoelectric or Peltier device to flex and bend. Additionally, the flexible polyimide, elongated slots 36, and bridge portions 38 of the cover layer 30 and base layer 32 allow the top and bottom circuits 12, 14 to flex and bend. Such a flexible thermoelectric engine 10 is beneficial for use on a surface such as a seating surface of a vehicle seat to allow the engine 10 to conform to the shape of the seating surface, flex with the seating surface during occupant use, and be undetected by the occupant on the seating surface.

The invention has been described in an illustrative manner, and it is to be understood that the terminology, which has been used, is intended to be in the nature of words of description rather than of limitation. Many modifications and variations of the present invention are possible in light of the above teachings. It is, therefore, to be understood that within the scope of the appended claims, the invention may be practiced other than as specifically described.

## Claims

1. A thermoelectric engine (10) for heating and cooling a surface comprising:
a top circuit (12) and bottom circuit (14);
a thermoelectric device (16) electrically connected between said top and bottom circuits (12, 14);
said top and bottom circuits (12, 14) include a plurality of spaced apart conductors (34) bonded to a base layer (32), wherein said base layer (32) includes a plurality of elongated slots (36) spaced apart by a bridge (38) of base layer material for allowing said top and bottom circuits (12, 14) to flex between said conductors (34);
wherein said thermoelectric device (16) includes a plurality of alternating N-elements (22) and P-elements (24),
**characterized in that** the plurality of alternating N-elements (22) and P-elements (24) are spaced apart by a flexible insulator (26) to allow said thermoelectric device (16) to flex between said top and bottom circuits (12, 14).

2. The thermoelectric engine (10) as set forth in claim 1 wherein said thermoelectric device (16) is soldered between said top and bottom circuits (12, 14).

3. The thermoelectric engine (10) as set forth in claim 2 wherein at least one of said top and bottom circuits (12, 14) includes a cover layer (30) and a base layer (32) and wherein said conductors (34) are adhered between said cover layer (30) and said base layer (32).

4. The thermoelectric engine (10) as set forth in claim 3 wherein each of said cover layer (30) and said base layer (32) includes said plurality of elongated slots (36) spaced apart by a bridge (38) of layer material for allowing said cover layer (30) and base layer (32) to flex between said conductors (34).

5. The thermoelectric engine (10) as set forth in claim 4 wherein said cover layer (30) and said base layer (32) are comprised of polyimide material.

6. The thermoelectric engine (10) as set forth in claim 5 wherein said conductors (34) are copper conductors (34) electrically coupled to said thermoelectric device (16).

7. The thermoelectric engine (10) as set forth in claim 6 wherein said top circuit (12) and said bottom circuit (14) are interconnected by a flexible hinge (40) to wrap around said thermoelectric device (16) and form said top and bottom circuits (12, 14).

## Patentansprüche

1. Thermoelektrischer Motor (10) zum Beheizen und Kühlen einer Oberfläche, umfassend:
einen oberen Stromkreis (12) und einen unteren Stromkreis (14) ;
eine elektrisch zwischen dem oberen und unteren Stromkreis (12, 14) angeschlossene thermoelektrische Vorrichtung (16);
wobei der obere und untere Stromkreis (12, 14) mehrere voneinander beabstandete, mit einer Basisschicht (32) verbundene Leiter (34) umfassen, wobei die Basisschicht (32) mehrere durch eine Brücke (38) aus Basisschichtmaterial voneinander beabstandete längliche Schlitze (36), um zu ermöglichen, dass sich der obere und untere Stromkreis (12, 14) zwischen den Leitern (34) biegen können, umfasst;
wobei die thermoelektrische Vorrichtung (16) mehrere alternierende N-Elemente (22) und P-Elemente (24) umfasst,
**dadurch gekennzeichnet, dass** die mehreren alternierenden N-Elemente (22) und P-Elemente (24) durch einen biegsamen Isolator (26) voneinander beabstandet sind, um zu ermöglichen, dass sich die thermoelektrische Vorrichtung (16) zwischen dem oberen und unteren Stromkreis (12, 14) biegen kann.

2. Thermoelektrischer Motor (10) nach Anspruch 1, wobei die thermoelektrische Vorrichtung (16) zwischen den oberen und unteren Stromkreis (12, 14) gelötet ist.

3. Thermoelektrischer Motor (10) nach Anspruch 2, wobei wenigstens einer des oberen und unteren Stromkreises (12, 14) eine Deckschicht (30) und eine Basisschicht (32) umfasst, und wobei die Leiter (34) zwischen der Deckschicht (30) und der Basisschicht (32) haftverbunden sind.

4. Thermoelektrischer Motor (10) nach Anspruch 3, wobei die Deckschicht (30) und die Basisschicht (32) jeweils die mehreren durch eine Brücke (38) aus Basisschichtmaterial voneinander beabstandeten länglichen Schlitze (36), um zu ermöglichen, dass sich die Deckschicht (30) und die Basisschicht (32) zwischen den Leitern (34) biegen können, umfasst.

5. Thermoelektrischer Motor (10) nach Anspruch 4, wobei die Deckschicht (30) und die Basisschicht (32) ein Polyimidmaterial umfassen.

6. Thermoelektrischer Motor (10) nach Anspruch 5, wobei die Leiter (34) elektrisch mit der thermoelektrischen Vorrichtung (16) gekoppelte Kupferleiter (34) sind.

7. Thermoelektrischer Motor (10) nach Anspruch 6, wobei der obere Stromkreis (12) und der untere Stromkreis (14) durch ein biegsames Scharnier (40) miteinander verbunden sind, um sich um die thermoelektrische Vorrichtung (16) herumzulegen und den oberen und unteren Stromkreis (12, 14) auszubilden.

## Revendications

1. Moteur thermoélectrique (10) pour chauffer et refroidir une surface, comprenant :
un circuit supérieur (12) et un circuit inférieur (14) ;
un dispositif thermoélectrique (16) connecté électriquement entre ledit circuit supérieur et ledit circuit inférieur (12, 14) ;
ledit circuit supérieur et ledit circuit inférieur (12, 14) incluent une pluralité de conducteurs espacés (34) collés sur une couche de base (32), dans lequel ladite couche de base (32) inclut une pluralité de fentes allongées (36) espacées par un pont (38) de matériau de couche de base pour permettre audit circuit supérieur et audit circuit inférieur (12, 14) de fléchir entre lesdits conducteurs (34) ;
dans lequel ledit dispositif thermoélectrique (16) comprend une pluralité d'éléments N (22) et d'éléments P (24) en alternance,
**caractérisé en ce que** la pluralité d'éléments N (22) et d'éléments P (24) en alternance sont espacés par un isolateur flexible (26) pour permettre audit dispositif thermoélectrique (16) de fléchir entre ledit circuit supérieur et ledit circuit inférieur (12, 14).

2. Moteur thermoélectrique (10) selon la revendication 1, dans lequel ledit dispositif thermoélectrique (16) est soudé entre ledit circuit supérieur et ledit circuit inférieur (12, 14).

3. Moteur thermoélectrique (10) selon la revendication 2, dans lequel au moins un circuit parmi ledit circuit supérieur et ledit circuit inférieur (12, 14) inclut une couche de couverture (30) et une couche de base (32), et dans lequel lesdits conducteurs (34) sont en adhésion entre ladite couche de couverture (30) et ladite couche de base (32).

4. Moteur thermoélectrique (10) selon la revendication 3, dans lequel chaque couche parmi ladite couche de couverture (30) et ladite couche de base (32) inclut ladite pluralité de fentes allongées (36) espacées par un pont (38) d'un matériau en couche pour permettre à ladite couche de couverture (30) et à ladite couche de base (32) de fléchir entre lesdits conducteurs (34).

5. Moteur thermoélectrique (10) selon la revendication 4, dans lequel ladite couche de couverture (30) et ladite couche de base (32) comprennent un matériau polyimide.

6. Moteur thermoélectrique (10) selon la revendication 5, dans lequel lesdits conducteurs (34) sont des conducteurs en cuivre (34) électriquement couplés audit dispositif thermoélectrique (16).

7. Moteur thermoélectrique (10) selon la revendication 6, dans lequel ledit circuit supérieur (12) et ledit circuit inférieur (14) sont interconnectés par une articulation flexible (40) pour s'enrouler autour dudit dispositif thermoélectrique (16) et former ledit circuit supérieur et ledit circuit inférieur (12, 14).
